# EUROPÄISCHE PATENTSCHRIFT

(11) **EP 3 839 105 B1**
(45) Veröffentlichungstag und Bekanntmachung des Hinweises auf die Patenterteilung: **23.02.2022**
(21) Anmeldenummer: 20000462.0
(22) Anmeldetag: 11.12.2020
(51) Int. Cl.: C30B 25/16, C30B 29/40, C30B 29/42, H01L 21/02

(54) **GASPHASENEPITAXIEVERFAHREN**
GAS PHASE EPITAXY METHOD
PROCÉDÉ D'ÉPITAXIE EN PHASE GAZEUSE

(30) Priorität: 20.12.2019 DE 102019008929
(43) Veröffentlichungstag der Anmeldung: 23.06.2021
(73) Patentinhaber: AZUR SPACE Solar Power GmbH, 74072 Heilbronn (DE)
(72) Erfinder: Wächter, Clemens, 74348 Lauffen am Neckar (DE); Keller, Gregor, 74080 Heilbronn (DE); Fuhrmann, Daniel, 74081 Heilbronn (DE)
(74) Vertreter: Koch Müller Patentanwaltsgesellschaft mbH

(56) Entgegenhaltungen:
- EP-A2- 1 385 215
- US-A- 3 416 047
- US-A- 3 508 126

## Beschreibung

Die Erfindung betrifft ein Gasphasenepitaxieverfahren.

Es sind die unterschiedlichsten Gasphasenepitaxie-Anlagen, z.B. von der Fa. Aixtron, zum epitaktischen Erzeugen von Halbleiterschichten bekannt. Des Weitern sind aus der EP 1 385 215 A2, der US 3 416 047 A und der US 3 508 126 A Gasphasenepitaxieverfahren bekannt.

Den Anlagen gemein ist, dass die epitaktischen Schichten aus der Gasphase auf einem in einer Reaktionskammer eingebrachten Substrat abgeschieden bzw. aufgewachsen werden. Hierzu wird die Reaktionskammer aufgeheizt und ein Epitaxie-Gasfluss in die Reaktionskammer eingeleitet.

Die Zusammensetzung des Gasflusses richtet sich nach der Art der zu wachsenden Schicht, wobei typischerweise Präkursoren, wie z.B. Arsin und/oder TMGa, die Elemente für die zu wachsende Halbleiterschicht liefern und für eine Dotierung der Schicht gegebenenfalls auch Präkursoren für einen Dotierstoff zugegeben werden. Die Präkursoren werden mittels eines Trägergases in die Reaktionskammer geleitet. Um die Zusammensetzung des Gasflusses zu kontrollieren werden typischerweise Massestromregler eingesetzt.

Zu beachten ist allerdings auch, dass aufgrund der Reaktorhistorie auch noch andere unerwünschte Elemente aus vorherigen Prozessen In der Reaktionskammer vorhanden sein können. Gerade für das Erzeugen niedrig dotierter Schichten kann dies problematisch werden.

Vor diesem Hintergrund besteht die Aufgabe der Erfindung darin, ein Verfahren anzugeben, das den Stand der Technik weiterbildet.

Die Aufgabe wird durch ein Verfahren mit den Merkmalen des Patentanspruchs 1 gelöst. Vorteilhafte Ausgestaltungen der Erfindung sind Gegenstand von Un teransprüchen.

Gemäß dem Gegenstand der Erfindung wird ein Gasphasenepitaxieverfahren mit dem Verfahrensschritt Aufwachsen einer III-V-Schicht mit einer sich von einem ersten Leitfähigkeitstyp zu einem zweiten Leitfähigkeitstyp ändernden Dotierung auf einer Oberfläche eines Substrats oder einer vorausgehenden Schicht bereitgestellt.

Der erste Leitfähigkeitstyp ist p und der zweite Leitfähigkeitstyp ist n.

In einer Reaktionskammer wird aus der Gasphase aus einem Epitaxie-Gasfluss die III-V-Schicht aufgewachsen.

Der Epitaxie-Gasfluss weist ein Trägergas und mindestens einen ersten Präkursor für ein Element aus der III. Hauptgruppe und mindestens einen zweiten Präkursor für ein Element aus der V. Hauptgruppe auf.

Außerdem wird bei Erreichen einer ersten Aufwachshöhe mittels eines Verhältnisses eines ersten Massestroms des ersten Präkursors zu einem zweiten Massestrom des zweiten Präkursors in dem Epitaxie-Gasfluss und mit oder ohne Zugabe eines weiteren Präkursors für einen Dotierstoff des ersten Leitfähigkeitstyps zu dem Epitaxie-Gasfluss ein erster Dotierungsausgangswert des ersten Leitfähigkeitstyps eingestellt.

Anschließend wird der erste Dotierungsausgangswert durch Zugabe eines dritten Massestroms eines dritten Präkursors für einen Dotierstoff des zweiten Leitfähigkeitstyps zu dem Epitaxie-Gasfluss und/oder durch Ändern des Verhältnisses des ersten Massestroms zu dem zweiten Massestrom sprunghaft auf einen zweiten Dotierungsausgangswert des ersten Leitfähigkeitstyps gesenkt oder auf einen zweiten Dotierungsausgangswert des zweiten Leitfähigkeitstyps von höchstens 1•10¹⁵ cm⁻³ eingestellt.

Wiederum anschließend, also nach Erreichen des zweiten Dotierungsausgangswerts, wird durch schrittweises oder kontinuierliches Erhöhen des Massestroms des dritten Präkursors und/oder durch schrittweises oder kontinuierliches Ändern des Verhältnisses zwischen dem ersten Massestrom und dem zweiten Massestrom eine Dotierung der III-V-Schicht über eine Übergangsbereichsschicht mit einer Aufwachshöhe von mindestens 10 µm schrittweise oder kontinuierlich bis zu einem Erreichen eines Dotierungszielwerts des zweiten Leitfähigkeitstyps geändert.

Es versteht sich, dass eine III-V-Schicht mindestens eine Komponente oder auch mehrere Komponenten der III. Hauptgruppe, z.B. Aluminium oder Gallium und mindestens eine Komponente oder mehrere Komponenten der V. Hauptgruppe, z.B. Indium oder Arsen oder Phosphor aufweist.

Als Präkursor werden Moleküle bezeichnet, welche als Ausgangsprodukt für das epitaktische Wachstum dienen. Ein Präkursor ist entsprechend Molekül bestehend aus einem aufzuwachsenden Element, z.B. einem Element der III. oder V. Hauptgruppe oder einem Dotierstoff, und mindestens einem weiteren Element.

Insbesondere bei metallorganischen Präkursoren, z.B. TMGa, ist mindestens ein weiteres Element z.B. Kohlenstoff vorhanden, welcher während des Aufwachsens freigesetzt wird und als Dotierstoff wirkt.

Wird ein Präkursor für einen Dotierstoff zugefügt, so spricht man von aktiver Dotierung, während ein Dotieren mittels des Kohlenstoffs eines metallorganischen Präkursors als Autodoping bezeichnet wird.

Die Höhe sowie die Art der Dotierung einer III-V-Schicht ist auch von dem Mengenverhältnis zwischen dem Element der III. Hauptgruppe und dem Element der V. Hauptgruppe in der Reaktionskammer abhängig.

Je nach Art und Größe der verwendeten Gasphasen-Anlage schwankt dieses Mengenverhältnis innerhalb der Reaktionskammer, d.h. an unterschiedlichen Orten weist der ankommende Gasfluss unterschiedliche V-III-Mengenverhältnisse auf. Solche Schwankungen können im Bereich einer eln-zelnen Halbleiterscheibe und/oder über mehrere Halbleiterscheiben hinweg auftreten. Es sei angemerkt, dass mit dem Begriff der Halbleiterscheibe auch Substratscheiben ohne eine weitere Schicht umfasst sind.

Es versteht sich, dass das Ändern des Massestroms oder das Ändern des Verhältnisses von zwei unterschiedlichen Masseströmen äquivalent mit dem Ändern eines entsprechen Partialdrucks bzw. Partialdruckverhältnisses bzw. grundsätzlich äquivalent mit jeder Mengenkontrolle/-änderung ist.

Es versteht sich auch, dass das Einstellen der genannten Dotierungswerte während des Aufwachsens geschieht bzw. dass durchgehend aufgewachsen und während des Wachsens bzw. Abscheidens die Masseströme geändert werden.

Dabei schließen sich die einzelnen Schritte, also der Dotierungssprung an das Einstellen des ersten Dotierungsausgangswert bzw. die kontinuierliche Änderung bis zu dem Dotierungszielwert an den Dotierungssprung, entweder zeitlich direkt aneinander an oder sie finden zeitlich verzögert statt, wobei sich bei einer zeitlichen Verzögerung und ohne weitere Änderungen an dem Epitaxie-Gasfluss entsprechend noch eine Schicht mit konstanter Dotierung ausbildet.

Zuerst wird der erste Dotierungsausgangswert des ersten Leitfähigkeitstyps eingestellt. Beispielsweise weist eine vorab gewachsene Schicht eine Dotierung des ersten Leitfähigkeitstyps mit abnehmendem Verlauf auf, wobei bei der ersten Aufwachshöhe der erste Dotierungsausgangswert erreicht ist.

Durch die Änderung des Masseflusses des dritten Präkursors während des Wachsens der Übergangsbereichsschicht lässt sich ein reproduzierbarer Verlauf im Bereich des p-n Übergangs erzielen.

Eine unerwünschte Ausbildung von seriellen mehrfach p/n Übergängen lassen sich auf den Halbleiterscheiben ebenso wie eine Ausbildung von lokalen Unterschieden in den Dotierstoffverläufen auf den Halbleiterscheiben oder zwischen den Halbleiterscheiben zuverlässig unterdrücken.

Ein Weiterer Vorteil ist, dass sich eine Kreuzkontamination, beispielsweise aus der Belegung der Reaktorkammer aus vorangegangenen Epitaxiephasen, zuverlässig und wirkungsvoll unterdrücken lässt und sich Schichten mit niedrigen Dotierungen unterhalb von 5·10¹⁵ cm⁻³ und insbesondere p / n Übergänge ausgehend von einer p-Dotierung zuverlässig herstellen lassen.

Ausgehend von einem konstanten V / III Verhältnis während des Wachsens der Übergangsbereichsschicht von wenigstens 10 µm, lassen sich die bisherigen auf den Halbleiterscheiben stark schwankenden Sperrspannungen, mit Unterschieden von mehr als 100 V, deutlich reduzieren.

Anders ausgedrückt, lokale Dotierungsunterschiede auf der Halbleiterscheibe bedingt durch Schwankungen des V / III Verhältnisses und / oder bedingt durch unterschiedliche Hintergrunddotierungen in der Epitaxie-Anlage werden reduziert.

Alternativ weist die vorausgehende Schicht oder das Substrat bereits eine dem Dotierungsausgangswert entsprechende Dotierung auf, so dass sich das Einstellen bei Erreichen der ersten Aufwachshöhe auf einem Beibehalten der Einstellungen entspricht.

In einer weiteren Alternative weist die vorab gewachsene Schicht oder das Substrat eine höhere Dotierung auf, wobei die Dotierung sprunghaft, schrittweise oder kontinuierlich bis zu der ersten Aufwachshöhe auf den ersten Ausgangswert gesenkt wird.

Anschließend wird die Dotierung sprunghaft, also ohne Zwischenschritte und über eine sehr geringe Aufwachshöhe, z.B. höchstens einige Nanometer, reduziert.

Der Dotierungszielwert wird anschließend über eine Rampe oder Treppe, also eine kontinuierliche oder schrittweise Änderung der Dotierung in der aufwachsenden Schicht über die Übergangsbereichsschicht hinweg erreicht.

Die sprunghafte Änderung der Dotierung wie auch die kontinuierliche oder stufenförmige Änderung der Dotierung über die Übergangsbereichsschicht erfolgt entweder ausschließlich durch Erhöhung des Massenstroms des dritten Präkursors, z.B. Silan, oder das Mengenverhältnis zwischen den Elementen der III. und V. Hauptgruppe, also zwischen dem ersten und zweiten Massestrom wird zusätzlich geändert.

In einer weiteren Alternativen werden die Änderungen der Dotierung allein durch eine Änderung des Mengenverhältnisses zwischen den Elementen der III. und V. Hauptgruppe bewirkt.

Es versteht sich, dass auch alle Kombinationen möglich sind bzw. die sprunghafte Dotierungsänderung unabhängig von der rampen- oder treppenförmigen Dotierungsänderung ist und die Methode daher unabhängig voneinander wählbar ist.

Auch versteht es sich, dass der Epitaxie-Gasfluss auch bei dem Einstellen des ersten Dotierungsausgangswerts bereits einen gegebenenfalls geringen Massefluss des dritten Präkursors aufweisen kann, wobei die Präsenz des Dotierstoffs des zweiten Leitfähigkeitstyps mittels des V-III-Verhältnisses und/oder des Massestroms des weiteren Präkursors entsprechend ausgeglichen wird. Als Trägergase für die Epitaxie-Gasflüsse eignet sich beispielsweise H₂ oder N₂.

Aufgrund von örtlichen Unterschieden im V-III-Verhältnis und/oder von Hintergrunddotierungen kann ein sprunghafter p-n Übergang gerade bei niedrigen Dotierungen zu sehr unterschiedlichen Sperrspannungen über einzelne Halbleiterscheibe und/oder mehrere Halbleiterscheiben hinweg führen. Durch das sprunghafte Ändern zu Beginns des Übergangsbereichs, also von einem noch mit Sicherheit den ersten Leitfähigkeitstyps aufweisenden Dotierungswert auf einen z.B. sehr niedrigen Dotierungswert des ersten oder des zweiten Leitfähigkeitstyps und die schrittweise oder kontinuierliche weitere Änderung in den Dotierungsbereich des zweiten Leitfähigkeitstyps hinein über eine Übergangsbereichsschicht mit einer gewissen Schichtdicke lässt sich ein reproduzierbarer Verlauf des p-n Übergangs erzielen.

Ein Vorteil der Erfindung ist somit, dass auf einfache und reproduzierbare Weise ohne besondere Anforderungen an die verwendete GasphasenEpitaxie-Anlage zuverlässig hohe Spannungsfestigkeiten oberhalb 200 V erreicht werden.

Ein Vorzug des Verfahrens besteht darin, dass sich das Gasphasenepitaxieverfahren unter Nutzung eines geringen Flusses des zweiten Präkursors für die Gruppe V durchführen lässt. Wird insbesondere für den zweiten Präkursor Arsin oder TGMa verwendet, lassen sich mittels eines geringen Flusses des zweiten Präkursors die Herstellungskosten deutlich senken und die Umweltfreundlichkeit des Herstellungsprozesses stark erhöhen.

Durch die schrittweise oder kontinuierliche Änderung der Dotierung über die Dicke einer Übergangsbereichsschicht bei einem konstanten oder nahezu konstanten V/III Verhältnis der Masseströme, wird dagegen ein über die gesamte Reaktionskammer hinweg reproduzierbarer Verlauf des p-n Übergangs erreicht auf der Halbleiterscheiber erreicht.

Die Unterschiede im ankommenden Gasfluss wirken sich lediglich auf die absolute Wachstumstiefe des Übergangs aus, wobei die Unterschiede in der absoluten einen geringeren Einfluss auf die erreichten Sperrspannungen haben als ein nicht reproduzierbarer Dotierungsverlauf des p-n Übergangs

In einer weiteren Ausführungsform beträgt der erste Dotierungsausgangswert des ersten Leitfähigkeitstyps höchstens 5·10¹⁶ cm⁻³ oder höchstens 1·10¹⁶ cm⁻³.

Gemäß einer anderen Ausführungsform beträgt der zweite Dotierungsausgangswert des ersten Leitfähigkeitstyps höchstens 5·10¹⁵ cm⁻³ oder höchstens 1·10¹⁵ cm⁻³³ oder höchstens 5·10¹⁴ cm⁻³ oder höchstens 1·10¹⁴ cm⁻³.

In einer anderen Weiterbildung beträgt der Dotierungszielwert des zweiten Leitfähigkeitstyps höchstens 1·10¹⁵ cm⁻³ oder höchstens 5·10¹⁴ cm⁻³ oder höchstens 1·10¹⁴ cm⁻³ beträgt.

Gemäß einer weiteren Weiterbildung beträgt die Aufwachshöhe des Übergangsbereichs mindestens 30 µm oder mindestens 60 µm.

In einer anderen Ausführungsform wird die Dotierung über die Übergangsbereichsschicht um höchstens 1·10¹³ cm⁻³ über 5 µm Aufwachshöhe geändert.

Gemäß einer weiteren Ausführungsform wird die Dotierung über die Übergangsbereichsschicht in mindestens vier Schritten geändert .

In weiteren Ausführungsformen ist das Element der III. Hauptgruppe Gallium und das Element der V. Hauptgruppe Arsen und/oder ist der dritte Präkursor Monosilan.

In einer Weiterbildung wird nach dem Erreichen eines n-Dotierungszielwerts über eine Aufwachshöhe ein zweiter n-Dotierungszielwert durch sprunghaftes Ändern des dritten Massestroms und/oder durch sprunghaftes Ändern des Verhältnisses des ersten Massestroms zu dem zweiten Massestrom eingestellt, wobei der zweite n-Dotierungszielwert größer als der n-Dotierungszielwert ist.

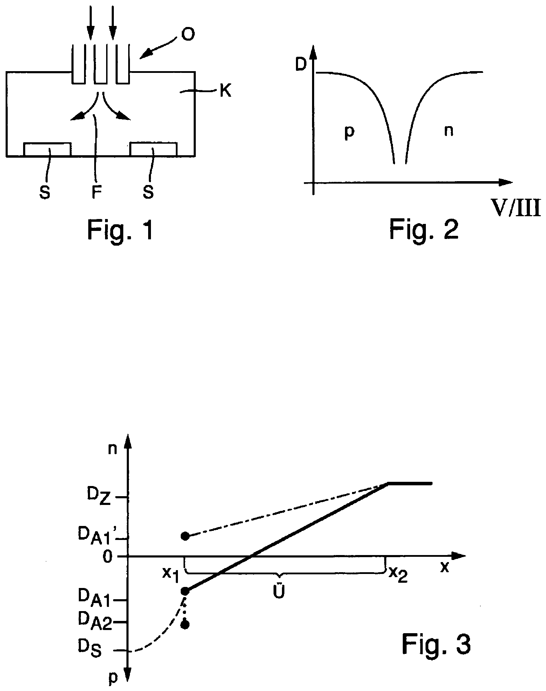

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigen, die
- Figur 1: einen Querschnitt von in einer Reaktionskammer angeordneten Substraten,
- Figur 2: einen Zusammenhang zwischen einer Dotierung und einem Verhältnis von Elementen der V. Hauptgruppe zu Elementen der III. Hauptgruppe während des epitaktischen Wachstums,
- Figur 3: einen Dotierstoffkonzentrationsverlauf über eine gewachsene III-V-Schicht gemäß einer ersten erfindungsgemäßen Ausführungsform des Gasphasenepitaxieverfahrens,
- Figur 4: einen Dotierstoffkonzentrationsverlauf über eine gewachsene III-V-Schicht gemäß einer zweiten erfindungsgemäßen Ausführungsform des Gasphasenepitaxieverfahrens,
- Figur 5: einen Verlauf des Massestroms des dritten Präkursors über eine gewachsene III-V-Schicht des Gasphasenepitaxieverfahrens.
Die Abbildung der Figur 1 zeigt schematisch einen Querschnitt einer Reaktorkammer K einer Gasphasenepitaxie-Anlage. Auf einem Boden der Reaktorkammer K sind Substrate S angeordnet. Außerdem weist die Reaktorkammer K ein Gaseinlassorgan O auf, durch welches der Epltaxie-Gasfluss F in die Reaktorkammer K eingeleitet wird.

Der Epitaxie-Gasfluss F weist ein Trägergas, mindestens einen ersten metallorganischen Präkursor für ein Element der III. Hauptgruppe, z.B. TMGa, einen zweiten Präkursor für ein Element der V. Hauptgruppe, z.B. Arsin, und einen dritten Präkursor für einen n-Dotierstoff, z.B. Silan, auf.

Das Gaseinlassorgan O weist mehrere in der Reaktorkammer K endende Leitungen auf, durch welche jeweils eine Komponente oder mehrere Komponenten des Epitaxie-Gasflusses F zu der Reaktorkammer K geleitet werden.

In der Abbildung der Figur 2 ist in einem Diagramm die Abhängigkeit der Dotierung von einem Mengenverhältnis der Elemente der V. und III. Hauptgruppe aufgetragen. Insbesondere wird deutlich, dass nicht nur die Höhe einer Dotierung, sondern auch die Art der Dotierung, also n oder p, durch das V-III-Verhältnis, also das Mengenverhältnis in dem Gasfluss, eingestellt werden kann.

Andererseits wird deutlich, dass Schwankungen des V-III-Verhältnisses über der Halbleiterscheibe bzw. einem Substrat zu unterschiedlichen Dotierungen führt und dass sich solche Schwankungen gerade bei niedrigen Dotierungen besonders stark auswirken.

Eine erste Ausführungsform des erfindungsgemäßen Gasphasenepitaxieverfahrens ist in der Abbildung der Figur 3 anhand eines Verlaufs der Dotierung D über eine Aufwachshöhe x veranschaulicht.

Zuerst bzw. bei einer ersten Aufwachshöhe x₁ wird ein erster Dotierungsausgangswert D_{A1} des ersten Leitfähigkeitstyps mittels des Verhältnisses eines ersten Massestroms des ersten Präkursors, z.B. TMGa, zu einem zweiten Massestrom des zweiten Präkursor, z.B. Arsin, in dem Epitaxie-Gasfluss F und mit oder ohne Zugabe eines weiteren Massestroms eines weiteren Präkursors für einen Dotierstoff des ersten Leitfähigkeitstyps, z.B. Kohlenstofftetrabromid oder Dimethylzink, zu dem Epitaxie-Gasfluss F eingestellt.

Anschließend wird ein dritter Massestrom eines dritten Präkursors für einen Dotierstoff des zweiten Leitfähigkeitstyps, z.B. Silan, zugegeben und/oder das Verhältnis zwischen dem ersten und zweiten Massestrom sprunghaft geändert, um einen zweiten Dotierungsausgangswert D_{A2} des ersten Leitfähigkeitstyps oder (gestrichelt eingezeichnet) einen zweiten Dotierungsausgangswert D_{A2}∗ des zweiten Leitfähigkeitstyps einzustellen.

Anschließend wird der dritte Massestrom des dritten Präkursors und/oder das Verhältnis zwischen dem ersten und zweiten Massestrom über eine Übergangsbereichsschicht Ü kontinuierlich geändert, bis an bei einer zweiten Aufwachshöhe x₂ ein p-Dotierungszielwert D_{z} erreicht ist. Es versteht sich, dass sich der Übergangsschichtbereich Ü von der ersten Aufwachshöhe x₁ bis zur zweiten Aufwachshöhe x₂ erstreckt.

Anschließend wird der Epitaxie-Gasfluss F über einen weiteren Bereich der Aufwachshöhe x nicht weiter verändert, so dass die Dotierung der sich anschließenden III-V-Schicht konstant bleibt.

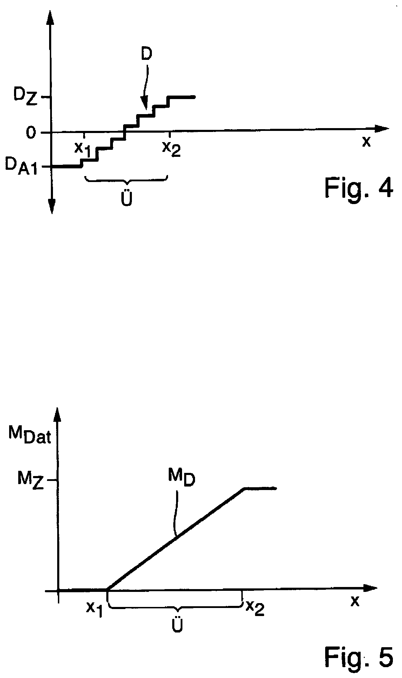

In der Abbildung der Figur 4 ist eine weitere Ausführungsform des erfindungsgemäßen Gasphasenepitaxieverfahrens anhand des Dotierungsverlaufs D veranschaulicht, wobei im Folgenden nur die Unterschiede zu den Abbildungen der Figuren 3 erläutert werden.

Die Änderung der Dotierung von dem n-Dotierungsausgangswert D_{A1} zu dem p-Dotierungszielwert D_{z} erfolgt in mehreren Schritten, so dass sich ein treppenförmiger Verlauf der Dotierung über die Übergangsbereichsschicht Ü einstellt.

In der Abbildung der Figur 5 ist eine weitere Ausführungsform des erfindungsgemäßen Gasphasenepitaxieverfahrens anhand des Verlauf des Massestroms MD über der Dicke der Übergangsbereichsschicht Ü von der ersten Aufwachshöhe x₁ bis zur zweiten Aufwachshöhe x₂ veranschaulicht, wobei im Folgenden nur die Unterschiede zu den Abbildungen der Figuren 4 erläutert werden.

Die Änderung der Massestroms MD erfolgt von einem Anfangswert MA der bei null oder nahe bei null liegt bis zu einem Zielwert MZ des Massestroms MZ des dritten Präkursors. Die Erhöhung des Massestroms lässt sich kontinuierlich oder zumindest stetig durchführen, d.h. es erfolgt ein gerade oder ein zumindest stetige Erhöhung der Dotierung über die Dicke der Übergangsbereichsschicht Ü. Vorliegend ist nur eine geradlinige Erhöhung des Massestroms eingezeichnet.

## Patentansprüche

1. Gasphasenepitaxieverfahren mit dem Verfahrensschritt:
- Aufwachsen einer III-V-Schicht mit einer sich von einem ersten Leitfähigkeitstyp zu einem zweiten Leitfähigkeitstyp ändernden Dotierung (D) auf einer Oberfläche eines Substrats oder einer vorausgehenden Schicht in einer Reaktionskammer (K) aus der Gasphase aus einem Epitaxie-Gasfluss (F) aufweisend ein Trägergas, mindestens einen ersten Präkursor für ein Element aus der III. Hauptgruppe und mindestens einen zweiten Präkursor für ein Element aus der V. Hauptgruppe, wobei
der erste Leitfähigkeitstyp p und der zweite Leitfähigkeitstyp n ist
- bei Erreichen einer ersten Aufwachshöhe mittels eines Verhältnisses eines ersten Massestroms des ersten Präkursors zu einem zweiten Massestrom des zweiten Präkursors in dem Epitaxie-Gasfluss (F) und mit oder ohne Zugabe eines weiteren Präkursors für einen Dotierstoff des ersten Leitfähigkeitstyps zu dem Epitaxie-Gasfluss (F) ein erster Dotierungsausgangswert (DA1) des ersten Leitfähigkeitstyps eingestellt wird,
- anschließend der erste Dotierungsausgangswert (DA1) durch Zugabe eines dritten Massestroms eines dritten Präkursors für einen Dotierstoff des zweiten Leitfähigkeitstyps zu dem Epitaxie-Gasfluss (F) und/oder durch Ändern des Verhältnisses des ersten Massestroms zu dem zweiten Massestrom sprunghaft auf einen zweiten Dotierungsausgangswert (DA2) des ersten Leitfähigkeitstyps gesenkt oder auf einen zweiten Dotierungsausgangswert (DA2^{∗}) des zweiten Leitfähigkeitstyps von höchstens 1•10¹⁵ cm⁻³ eingestellt wird und
- anschließend durch schrittweises oder kontinuierliches Erhöhen des Massestroms des dritten Präkursors und/oder durch schrittweises oder kontinuierliches Ändern des Verhältnisses zwischen dem ersten Massestrom zu dem zweiten Massestrom eine Dotierung (D) der III-V-Schicht über eine Übergangsbereichsschicht (Ü) mit einer Aufwachshöhe von mindestens 10 µm schrittweise oder kontinuierlich bis zu einem Erreichen eines Dotierungszielwerts (DZ) des zweiten Leitfähigkeitstyps geändert wird.

2. Gasphasenepitaxieverfahren nach Anspruch 1, **dadurch gekennzeichnet, dass** der erste Dotierungsausgangswert (DA1) des ersten Leitfähigkeitstyps höchstens 5•10¹⁶ cm⁻³ oder höchstens 1•10¹⁶ cm⁻³ beträgt.

3. Gasphasenepitaxieverfahren nach Anspruch 1 oder 2, **dadurch gekennzeichnet, dass** der zweite Dotierungsausgangswert (DA2) des ersten Leitfähigkeitstyps höchstens 5•10¹⁵ cm⁻³ oder höchstens 1•10¹⁵ cm⁻³ oder höchstens 5•10¹⁴ cm⁻³ oder höchstens 1•10¹⁴ cm⁻³ beträgt.

4. Gasphasenepitaxieverfahren nach einem der vorstehenden Ansprüche, **dadurch gekennzeichnet, dass** der Dotierungszielwert (DZ) des zweiten Leitfähigkeitstyps höchstens 1•10¹⁵ cm⁻³ oder höchstens 5•10¹⁴ cm⁻³ oder höchstens 1•10¹⁴ cm⁻³ beträgt.

5. Gasphasenepitaxieverfahren nach einem der vorstehenden Ansprüche, **dadurch gekennzeichnet, dass** die Aufwachshöhe des Übergangsbereichs mindestens 30 µm oder mindestens 60 µm beträgt.

6. Gasphasenepitaxieverfahren nach einem der vorstehenden Ansprüche, **dadurch gekennzeichnet, dass** die Dotierung (D) über die Übergangsbereichsschicht (Ü) in Schritten von höchstens 1•10¹³ cm⁻³ über 5 µm geändert wird.

7. Gasphasenepitaxieverfahren nach einem der vorstehenden Ansprüche, **dadurch gekennzeichnet, dass** die Dotierung (D) über die Übergangsbereichsschicht (Ü) in mindestens vier Schritten geändert wird.

8. Gasphasenepitaxieverfahren nach einem der vorstehenden Ansprüche, **dadurch gekennzeichnet, dass** das Element der III. Hauptgruppe Gallium und das Element der V. Hauptgruppe Arsen ist.

9. Gasphasenepitaxieverfahren nach einem der vorstehenden Ansprüche, **dadurch gekennzeichnet, dass** der dritte Präkursor Monosilan ist.

10. Gasphasenepitaxieverfahren nach einem der vorstehenden Ansprüche, **dadurch gekennzeichnet, dass** nach dem Erreichen des n-Dotierungszielwerts (DZ) über eine Aufwachshöhe ein zweiter n-Dotierungszielwert durch sprunghaftes Ändern des dritten Massestroms und/oder durch sprunghaftes Ändern des Verhältnisses des ersten Massestroms zu dem zweiten Massestrom eingestellt wird, wobei der zweite n-Dotierungszielwert größer als der n-Dotierungszielwert (DZ) ist.

## Claims

1. Gas phase epitaxy method, comprising the method step:
- growing a III-V layer with a doping (D), which changes from a first type of conductivity to a second type of conductivity, on a surface of a substrate or a preceding layer in a reaction chamber (K) from the gas phase from an epitaxy gas flow (F) comprising a carrier gas, at least one first precursor for an element from the III main group and at least one second precursor for an element from the V main group,
wherein
the first conductivity type is p and the second conductivity type is n
- on reaching a first growth height by means of a ratio of a first mass flow of the first precursor to a second mass flow of the second precursor in the epitaxy gas flow (F) and with or without addition of a further precursor for a doping substance of the first conductivity type to the epitaxy gas flow (F) a first doping start value (DA1) of the first conductivity type is set,
- subsequently the first doping start value (DA1) through addition of a third mass flow of a third precursor for a doping substance of the second conductivity type to the epitaxy gas flow (F) and/or through changing the ratio of the first mass flow to the second mass flow is abruptly reduced to a second doping start value (DA2) of the first conductivity type or is set to a second doping start value (DA2^{∗}) of the second conductivity type of at most 1·10¹⁵ cm⁻³ and
- subsequently through stepped or continuous increase in the mass flow of the third precursor and/or through stepped or continuous change in the ratio of the first mass flow to the second mass flow a doping (D) of the III-V layer is changed over a transition region layer (Ü) with a growth height of at least 10 µm in steps or continuously until reaching a doping target value (DZ) of the second conductivity type.

2. Gas phase epitaxy method according to claim 1, **characterised in that** the first doping start value (DA1) of the first conductivity type is at most 5·10¹⁶ cm⁻³ or at most 1•10¹⁶⁻ cm⁻³.

3. Gas phase epitaxy method according to claim 1 or 2, **characterised in that** the second doping start value (DA2) of the first conductivity type is at most 5•10¹⁵ cm⁻³ or at most 1•10¹⁵ cm⁻³ or at most 5•10¹⁴ cm⁻³ or at most 1•10¹⁴ cm⁻³.

4. Gas phase epitaxy method according to any one of the preceding claims, **characterised in that** the doping target value (DZ) of the second conductivity type is at most 1•10¹⁵ cm⁻³ or at most 5•10¹⁴ cm⁻³ or at most 1•10¹⁴ cm⁻³.

5. Gas phase epitaxy method according to any one of the preceding claims, **characterised in that** the growth height of the transition region is at least 40 µm or at least 60 µm.

6. Gas phase epitaxy method according to any one of the preceding claims, **characterised in that** the doping (D) is changed over the transition region layer (Ü) in steps from at most 1•10¹³ cm⁻³ over 5 µm.

7. Gas phase epitaxy method according to any one of the preceding claims, **characterised in that** the doping (D) is changed over the transition region layer (Ü) in at least four steps.

8. Gas phase epitaxy method according to any one of the preceding claims, **characterised in that** the element of the III main group is gallium and the element of the V main group is arsenic.

9. Gas phase epitaxy method according to any one of the preceding claims, **characterised in that** the precursor is silane.

10. Gas phase epitaxy method according to any one of the preceding claims, **characterised in that** after reaching the n doping target value (DZ) over a growth height a second doping target value is set by abrupt change in the third mass flow and/or by abrupt change in the ratio of the first mass flow to the second mass flow, wherein the second n doping target value is greater than the n doping target value (DZ).

## Revendications

1. Procédé d'épitaxie en phase gazeuse comprenant l'étape suivant :
- croissance d'une couche III-IV avec un dopage (D) variant d'un premier type de conductivité à un deuxième type de conductivité sur une surface d'un substrat ou d'une couche précédente dans une chambre de réaction (K) à partir de la phase gazeuse d'un flux de gaz d'épitaxie (F) présentant un gaz porteur, au moins un premier précurseur pour un élément du groupe III et au moins un deuxième précurseur pour un élément du groupe V,
selon lequel,
le premier type de conductivité étant p et le deuxième type de conductivité n,
- lorsqu'une première hauteur de croissance est atteinte par le biais du rapport d'un premier flux massique du premier précurseur avec un deuxième flux massique du deuxième précurseur dans le flux de gaz d'épitaxie (F), avec ou sans ajout d'un autre précurseur pour un agent de dopage du premier type de conductivité dans le flux de gaz d'épitaxie (F), une première valeur de sortie de dopage (DA1) du premier type de conductivité est fixée,
- puis la première valeur de sortie de dopage (DA1) est brusquement réduite, en ajoutant un troisième flux massique d'un troisième précurseur pour un agent de dopage du deuxième type de conductivité dans le flux de gaz d'épitaxie (F) et/ou en modifiant le rapport du premier flux massique avec le deuxième flux massique, au niveau d'une deuxième valeur de sortie de dopage (DA2) du premier type de conductivité ou fixée au niveau d'une deuxième valeur de sortie de dopage (DA2^{∗}) du deuxième type de conductivité de 1•10¹⁵ cm⁻³ maximum,
- puis, en augmentant par incréments ou en continu le flux massique du troisième précurseur et/ou en modifiant en continu le rapport entre le premier flux massique et le deuxième flux massique, un dopage (D) de la couche III-V est modifié par incréments ou en continu par via une couche de zone de transition (Ü) d'une hauteur de croissance d'au moins 10 µm jusqu'à atteindre une valeur-cible de dopage (DZ) du deuxième type de conductivité.

2. Procédé d'épitaxie en phase gazeuse selon la revendication 1, **caractérisé en ce que** la première valeur de sortie de dopage (DA1) du premier type de conductivité est de 5•10¹⁶ cm⁻³ maximum ou 1•10¹⁶ cm⁻³ maximum.

3. Procédé d'épitaxie en phase gazeuse selon la revendication 1 ou 2, **caractérisé en ce que** la deuxième valeur de sortie de dopage (DA2) du premier type de conductivité est de 5•10¹⁵ cm⁻³ maximum ou 1•10¹⁵ cm⁻³ maximum ou 5•10¹⁴ cm⁻³ maximum ou 1•10¹⁴ cm⁻³ maximum.

4. Procédé d'épitaxie en phase gazeuse selon une des revendications précédentes, **caractérisé en ce que** la valeur-cible de dopage (DZ) du deuxième type de conductivité est de 1•10¹⁵ cm⁻³ maximum ou 5•10¹⁴ cm⁻³ maximum ou 1•10¹⁴ cm⁻³ maximum.

5. Procédé d'épitaxie en phase gazeuse selon une des revendications précédentes, **caractérisé en ce que** la hauteur de croissance de la zone de transition est d'au moins 30 µm ou d'au moins 60 µm.

6. Procédé d'épitaxie en phase gazeuse selon une des revendications précédentes, **caractérisé en ce que** le dopage (D) est modifié via la couche de zone de transition (Ü) par incréments de 1•10¹³ cm⁻³ maximum sur 5 µm.

7. Procédé d'épitaxie en phase gazeuse selon une des revendications précédentes, **caractérisé en ce que** le dopage (D) est modifié via la couche de zone de transition (Ü) en au moins quatre incréments.

8. Procédé d'épitaxie en phase gazeuse selon une des revendications précédentes, **caractérisé en ce que** l'élément du groupe III est du gallium et l'élément du groupe V de l'arsenic.

9. Procédé d'épitaxie en phase gazeuse selon une des revendications précédentes, **caractérisé en ce que** le troisième précurseur est du monosilane.

10. Procédé d'épitaxie en phase gazeuse selon une des revendications précédentes, **caractérisé en ce qu'**après avoir atteint la valeur-cible de dopage n (DZ) sur une hauteur de croissance, une deuxième valeur-cible de dopage n est fixée en modifiant brusquement le troisième flux massique et/ou en modifiant brusquement le rapport du premier flux massique avec le deuxième flux massique, la deuxième valeur-cible de dopage n étant supérieure à la valeur-cible de dopage n (DZ).
